(19) Europäisches Patentamt
European Patent Office
Office européen des brevets

(11) **EP 2 710 390 B1**

(12) **FASCICULE DE BREVET EUROPEEN**

(45) Date de publication et mention
de la délivrance du brevet:
**22.11.2017 Bulletin 2017/47**

(21) Numéro de dépôt: **12720527.6**

(22) Date de dépôt: **15.05.2012**

(51) Int Cl.:
*G01R 31/36* (2006.01)     *H02M 3/155* (2006.01)

(86) Numéro de dépôt international:
**PCT/EP2012/059020**

(87) Numéro de publication internationale:
**WO 2012/156401 (22.11.2012 Gazette 2012/47)**

(54) **CONVERTISSEUR ÉLECTRONIQUE DE PUISSANCE**

ELEKTRONISCHER STROMWANDLER

ELECTRONIC POWER CONVERTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.05.2011 FR 1154238**

(43) Date de publication de la demande:
**26.03.2014 Bulletin 2014/13**

(73) Titulaires:
• **Centre National de la Recherche Scientifique (C.N.R.S.)**
  **75016 Paris (FR)**
• **Université de Franche-Comté**
  **25030 Besançon Cedex (FR)**

(72) Inventeurs:
• **DEPERNET, Daniel**
  **F-90300 VALDOIE (FR)**

• **BA, Oumar**
  **DAKAR (SN)**
• **BERTHON, Alain**
  **F-25700 VALENTIGNEY (FR)**

(74) Mandataire: **Lavoix**
  **2, place d'Estienne d'Orves**
  **75441 Paris Cedex 09 (FR)**

(56) Documents cités:
  **WO-A2-2011/004249     US-A1- 2007 257 681**
  **US-A1- 2008 048 662**

• **MAURACHER ET AL: "Dynamic modelling of lead/acid batteries using impedance spectroscopy for parameter identification", JOURNAL OF POWER SOURCES, ELSEVIER SA, CH, vol. 67, no. 1-2, 1 juillet 1997 (1997-07-01), pages 69-84, XP005857513, ISSN: 0378-7753, DOI: 10.1016/S0378-7753(97)02498-1**

EP 2 710 390 B1

**Description**

La présente invention concerne le domaine des sources d'énergie électrique, telles que les éléments de stockage d'énergie électrique de type batteries, les modules de supercondensateurs, les piles à combustibles etc.

La présente invention concerne plus spécifiquement la mesure de l'impédance de telles sources de stockage d'énergie.

La mesure de l'impédance d'une telle source d'énergie électrique est utile pour caractériser l'état de cette source en termes d'état de charge, de conditions de fonctionnement, de l'état de dégradation et/ou de l'état de vieillissement.

Classiquement, cette mesure est réalisée à l'aide d'un spectroscope d'impédance. Un tel dispositif constitue cependant un dispositif coûteux, encombrant et nécessite un mode opératoire hors-ligne, généralement en laboratoire, interdisant la caractérisation en ligne et en temps réel de la source d'énergie.

On connaît par ailleurs un convertisseur électronique de puissance, adapté pour, dans un premier mode de fonctionnement, recevoir en entrée des grandeurs électriques de tension et/ou courant depuis un premier dispositif, pour les traiter à l'aide de moyens de traitement aptes à mesurer lesdites grandeurs électriques et à asservir lesdites grandeurs électriques en fonction desdites mesures et de contraintes propres à un deuxième dispositif, et pour fournir les grandeurs adaptées de tension et/ou courant audit deuxième dispositif.

Le document WO 2011/004249 A2 décrit un appareil d'estimation de la température d'une batterie secondaire dans lequel une impédance de la batterie est située sur la base des courant et tension de la batterie quand un courant d'ondulation est mis en circulation dans la batterie.

Suivant un premier aspect, l'invention a pour objet un convertisseur électronique de puissance du type précité, caractérisé en ce que le convertisseur de puissance est adapté pour, dans un premier état d'un deuxième mode de fonctionnement du convertisseur, lorsqu'un des premier et deuxième dispositifs est une source d'énergie électrique, imposer la présence d'un courant continu d'une valeur déterminée aux bornes de ladite source d'énergie ; le convertisseur de puissance est adapté en outre pour mesurer des valeurs de courant et tension aux bornes de la source d'énergie pendant ledit premier état du deuxième mode de fonctionnement, pour déterminer, en fonction desdites valeurs de courant mesurées, une valeur de décalage en courant et, en fonction desdites valeurs de tension mesurées, une valeur de décalage en tension, lesdites valeurs de décalage de courant et de tension étant en fonction en outre d'une plage de fonctionnement des moyens de traitement ; le convertisseur de puissance est adapté pour exciter, dans un deuxième état du deuxième mode de fonctionnement, la source d'énergie par injection d'un courant alternatif à au moins une fréquence d'excitation fixée, ledit courant alternatif étant superposé au courant continu imposé déterminé ; et dans lequel les moyens de traitement sont adaptés, dans le deuxième état du deuxième mode de fonctionnement, pour mesurer des valeurs successives de courant et tension aux bornes de la source d'énergie suite à l'excitation à ladite fréquence d'excitation, après décalage desdites valeurs de courant, respectivement desdites valeurs de tension, en fonction de ladite valeur de décalage en courant déterminée, respectivement, de ladite valeur de décalage en tension déterminée ; le convertisseur électronique de puissance comprenant en outre des moyens pour déterminer l'impédance de la source d'énergie à la fréquence d'excitation fixée, en fonction des valeurs de courant et tension successivement mesurées.

L'invention permet donc de prendre en compte la fonctionnalité de spectroscopie d'impédance au sein d'un convertisseur électronique de puissance adapté pour le transfert d'énergie électrique.

L'invention permet de réaliser la mesure d'impédance spectrale de la source d'énergie in situ, sans ajout de matériel et sans modification sensible du convertisseur. L'invention est notamment particulièrement avantageuse dans le cas de systèmes embarqués, par exemple dans le cas de véhicules électriques ou hybrides, pour lesquels le coût et l'encombrement sont des facteurs prépondérants. Elle permet en effet de faciliter le diagnostic embarqué des batteries des véhicules et facilite à moindre coût leur maintenance.

Dans des modes de réalisation, le convertisseur électronique de puissance selon l'invention comporte en outre une ou plusieurs des caractéristiques suivantes :

- la valeur de décalage en courant, respectivement, la valeur de décalage en tension, est déterminée de manière à ce qu'une tension, respectivement un courant, mesuré(e) aux bornes de la source d'énergie pendant le premier état d'un deuxième mode de fonctionnement ajouté(e) à ladite valeur de décalage en courant, respectivement en tension, soit égale au point central de la plage de fonctionnement des moyens de traitement ;
- le convertisseur est adapté pour, dans le deuxième état du deuxième mode de fonctionnement, exciter la source d'énergie par injection d'un courant alternatif superposé au courant continu de ladite valeur déterminée, à plusieurs fréquences d'excitation successives fixées ;

les moyens de traitement étant aptes à mesurer des valeurs successives de courant et tension aux bornes de la source d'énergie suite à l'excitation de chaque fréquence d'excitation, après décalage desdites valeurs de courant, respectivement desdites valeurs de tension, en fonction en fonction de ladite valeur de décalage en courant déterminée, respectivement, de ladite valeur de décalage en tension déterminée ;
les moyens pour déterminer l'impédance étant adaptés pour déterminer l'impédance de la source d'énergie pour chaque fréquence d'excitation fixée, en fonction des valeurs de courant et tension successivement mesurées ;

- les moyens de traitement sont aptes, dans le deuxième état du deuxième mode de fonctionnement, à mesurer des valeurs successives de courant et tension aux bornes de la source d'énergie suite à l'excitation à ladite fréquence d'excitation, et après décalage desdites valeurs de courant, respectivement de tension, et après application d'une valeur multiplicative audites valeurs de courant, respectivement de tension, déterminée en fonction de l'excursion desdites valeurs mesurées et de la plage de fonctionnement des premiers moyens ;
- le convertisseur électronique comprend au moins un commutateur commandé, dans le premier mode et le deuxième mode de fonctionnement par un signal en créneau correspondant à une fréquence de commande et un rapport cyclique donnés, le convertisseur de puissance étant adapté, dans le premier état du deuxième mode de fonctionnement, pour faire varier la valeur du rapport cyclique jusqu'à obtenir ladite valeur déterminée du courant continu aux bornes de ladite source d'énergie ;
- le convertisseur électronique comprend au moins un commutateur commandé, dans le premier mode et le deuxième mode de fonctionnement, par un signal en créneau à une fréquence de commande donnée
  et les moyens de traitement sont aptes, dans le deuxième état du deuxième mode de fonctionnement, à mesurer des valeurs successives de courant et tension aux bornes de la source d'énergie suite à l'excitation à ladite fréquence d'excitation, à une fréquence d'échantillonnage égale à la fréquence de commande ou à un sous-multiple entier de cette fréquence de commande ;
- une fréquence d'excitation est définie par la relation suivante :

$$F_{exc} = \frac{F_e}{k \cdot N_{pts\_spect}}$$

où $F_{exc}$ est la fréquence d'excitation, $F_e$ la fréquence d'échantillonnage, $N_{pts\_spect}$ est le nombre de points, par période, de la valeur à mesurer à cette fréquence d'excitation, $F_{exc}$ et k entier supérieur ou égal à 1.

L'invention sera mieux comprise à la lecture de la description qui suit et à l'examen des figures qui l'accompagnent. Ces figures sont données à titre illustratif mais nullement limitatif de l'invention. Ces figures sont les suivantes :

- la figure 1 est une vue schématique d'un convertisseur de puissance dans un mode de réalisation de l'invention ;
- la figure 2 est un schéma illustrant la fonctionnalité de transfert d'énergie du convertisseur de puissance de la figure 1 ;
- la figure 3 est un graphe représentant, en fonction du temps t, en partie haute un signal de commande de l'interrupteur T1 et en partie basse, le courant $I_L$ obtenu en fonction de ce signal de commande ;
- la figure 4 est une vue schématisée de la batterie S ;
- la figure 5 représente un schéma illustrant le calibrage des mesures par le convertisseur de puissance 1 ;
- la figure 6 est une vue du schéma électronique pour des mesures et calibrages illustrés en figure 5 ;
- la figure 7 illustre le signal obtenu en sortie I_out en fonction du temps, pendant une mesure d'impédance par un convertisseur dans un mode de réalisation de l'invention ;
- la figure 8 illustre le signal obtenu en sortie Ialt_out en fonction du temps pendant une mesure d'impédance par un convertisseur dans un mode de réalisation de l'invention ;
- la figure 9a représente le spectre d'un signal à mesurer ;
- la figure 9b représente le spectre d'un signal à mesurer après filtrage anti-repliement partiel ;
- la figure 9c représente le spectre d'un signal à mesurer après filtrage anti-repliement partiel et échantillonnage à la fréquence d'échantillonnage Fe=$F_{PWM}$ ;
- la figure 10 représente pour une même abscisse représentant le temps, l'évolution de signaux de réglage (courbe 100), du signal de commande du commutateur $T_1$ (courbe 101), du courant dans la source (courbe 102) et le signal échantillonné à $F_e$=$F_{PWM}$ ;
- la figure 11 illustre le principe d'asservissement du courant d'excitation injecté dans la batterie S ;
- la figure 12 illustre les résultats de mesures des composantes alternatives de la tension (V) et du courant (I) pour une fréquence d'excitation de 1024 Hz ;
- la figure 13 illustre les résultats de mesures des composantes alternatives de la tension (V) et du courant (I) pour une fréquence d'excitation de 0,32 Hz.

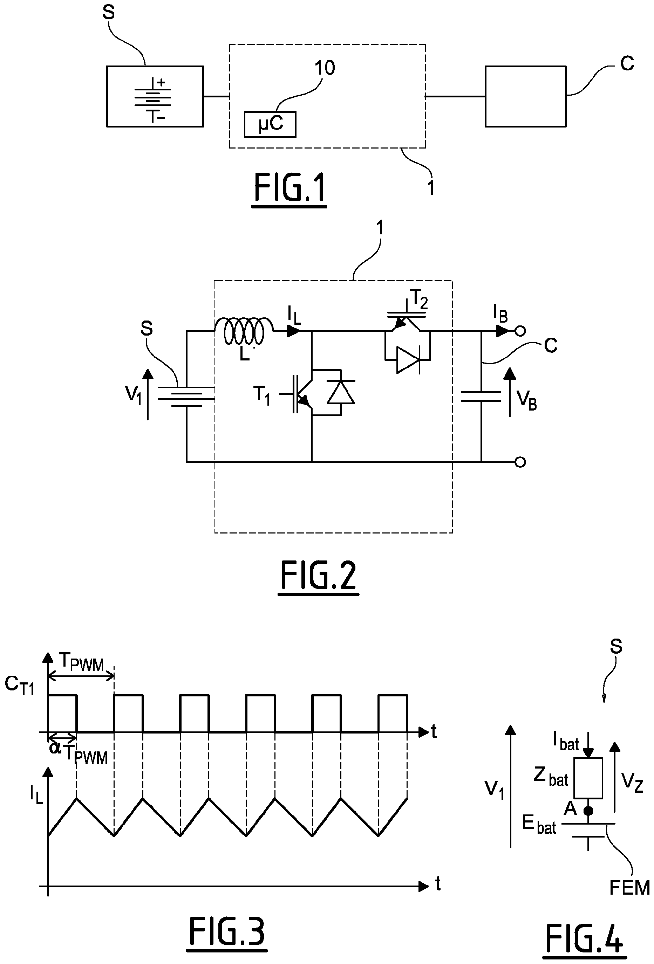

La figure 1 est une vue schématique d'un convertisseur de puissance 1 dans un mode de réalisation de l'invention.

De façon classique, le convertisseur de puissance 1 assure une fonction de transfert d'énergie entre une source S (batteries, supercondensateurs, piles à combustible) et une charge C, par exemple un réseau électrique continu, un moteur etc..

Lorsque la source S est réversible (par exemple les batteries et supercondensateurs), le transfert d'énergie peut être bidirectionnel. Le convertisseur de puissance 1 permet d'adapter les grandeurs électriques d'entrée, de type tension et/ou courant, aux grandeurs électriques de sortie (conversion continue/continue dans le cas présent).

De façon connue, le convertisseur comporte des interrupteurs (non représentés en figure 1), réalisés à l'aide de semi-conducteurs par exemple, permettant de modifier la tension et/ou le courant en conservant l'énergie. A l'aide des interrupteurs, la tension et/ou le courant est découpé(e) à très haute fréquence (par rapport à la fréquence d'entrée ou de sortie du convertisseur) et le résultat obtenu est lissé pour en extraire la valeur moyenne.

Le convertisseur 1 comporte en outre un microcontrôleur 10, qui assure le pilotage du convertisseur 1. Le microcontrôleur 10 permet de réaliser les mesures nécessaires à l'asservissement des grandeurs électriques à contrôler, de commander en MLI (Modulation de Largeur d'Impulsions) les semi-conducteurs du convertisseur 1 et d'assurer la sécurité du convertisseur.

La figure 2 est un schéma électrique illustrant la fonctionnalité de transfert d'énergie d'un convertisseur de puissance 1 dans un mode de réalisation de l'invention. Dans le cas considéré, la source S est une batterie, connectée à la charge C correspondant à un réseau continu, par l'intermédiaire du convertisseur de puissance 1, ici un convertisseur continu/continu de type élévateur réversible en courant, afin de permettre le transfert bidirectionnel d'énergie (charge et décharge de la batterie).

Ce type de convertisseur 1 est le plus représentatif des convertisseurs utilisés pour les applications de véhicule hybride en raison de sa fonction élévatrice de tension, le réseau continu ayant communément une tension supérieure à celle des batteries. Il est composé d'une inductance de lissage L et de deux transistors IGBTs $T_1$ et $T_2$ avec diode en antiparallèle. Les transistors $T_1$ et $T_2$ sont commandés complémentairement. Le signal de commande $C_{T1}$ de l'interrupteur $T_1$, représenté en partie haute de la figure 3, a une forme en créneau, une période $T_{PWM}$. Le rapport cyclique du signal de commande de $T_1$ est noté $\alpha$. En partie basse de la figure 3 est représentée la forme du courant $I_L$ dans la source S, obtenu suite à la commande de l'interrupteur $T_1$ représentée en partie haute de la figure 3.

Les valeurs moyennes des courants et tensions de la source et du réseau continu C sont liées par les relations :

$$\langle V_B \rangle = \frac{\langle V_1 \rangle}{1-\alpha} \quad \langle I_L \rangle = \frac{\langle I_B \rangle}{1-\alpha}$$

où $V_B$ est la tension aux bornes de la charge C, $V_1$ est la tension aux bornes de la source S, $I_B$ est le courant au niveau de la charge C, $I_L$ est le courant dans la source S.

Les variations de courant $I_L$ dans la période $T_{PWM}$ peuvent être réduites par augmentation de la valeur de l'inductance de la self L ou par augmentation de la fréquence de découpage $1/T_{PWM}$.

Cependant l'augmentation de l'inductance se fait au détriment de son coût, son poids et son encombrement tandis que l'augmentation de la fréquence de découpage contribue à l'augmentation des pertes par effets Joule dans les semi-conducteurs.

Outre la fonction de transfert d'énergie, le convertisseur de puissance 1 selon l'invention comporte en outre une fonctionnalité de mesure d'impédance de la source. Ainsi par rapport aux fonctionnalités usuelles d'un convertisseur de puissance, le convertisseur selon l'invention met en oeuvre une fonctionnalité de spectroscopie d'impédance moyennant :

- l'implantation d'algorithmes de contrôle complémentaires permettant l'excitation électrique fréquentielle de la source ;
- l'adaptation de l'électronique de mesure et son pilotage par le microcontrôleur 10 afin de permettre l'extraction les grandeurs utiles à la mesure d'impédance fréquentielle ;
- l'implantation d'algorithmes de traitement du signal temps réel permettant le calcul du spectre d'impédance.

Dans le mode de réalisation considéré, le contrôle du convertisseur 1 permettant la gestion d'énergie (fonction primaire du convertisseur), le pilotage de la spectroscopie d'impédance et les traitements de signaux associés sont réalisés par un unique microcontrôleur 10, par exemple de type DSP 16 bits à virgule fixe, avec une fréquence CPU de 30MHz.

Le microcontrôleur 10 utilisé est un TMS320LF2407, dédié aux applications de contrôle industriel. Les principales fonctionnalités matérielles intégrées au microcontrôleur 10 utilisées pour la mise en oeuvre de l'invention dans le convertisseur de puissance 1 sont :

- les sorties PWM (Pulse Width Modulation) ou MLI pour le pilotage des transistors du convertisseur de puissance 1 ;
- le convertisseur analogique numérique (CA/N) et les entrées analogiques associées pour la mesure des grandeurs analogiques ;
- le contrôleur SPI (Serial Peripheral Interface) ou série synchrone pour le pilotage de l'électronique de mesure (contrôle des gains et décalages programmables) ;
- le contrôleur SCI (Serial Communication Interface) ou RS232 pour la communication avec des interfaces externes (PC, console).

Comme illustré en figure 4, la batterie S peut être modélisée par une force électromotrice (FEM) en série avec une impédance. Ce modèle est également utilisable dans le cas des supercondensateurs et des piles à combustible.

La spectroscopie d'impédance consiste à mesurer l'impédance $Z_{bat}$ de la batterie sur une gamme de fréquence qui dépend des phénomènes à observer. L'impédance est déterminée à partir de la mesure de chaque composante fréquentielle du spectre de courant $I_{bat}$ circulant dans $Z_{bat}$ et de tension $V_Z$ aux bornes de $Z_{bat}$. Chaque composante de l'impédance à la fréquence f est donnée par l'expression :

$$\underline{Z_{bat}}(f) = \frac{\underline{V_Z}(f)}{\underline{I_{bat}}(f)} \text{ (notation complexe)}$$

Le point intermédiaire A entre la FEM et l'impédance étant interne à la batterie S et donc physiquement inaccessible, il est nécessaire de résoudre les difficultés suivantes :

- la tension aux bornes de $Z_{bat}$ est de très faible amplitude relativement à la FEM à vide et doit être mesurée avec une précision raisonnable tandis que $E_{bat}$ et $V_Z$ sont indissociables physiquement (la FEM à vide varie de quelques volts pour des éléments unitaires à plusieurs centaines de volts après association d'éléments (de1 à 600 volts par exemple), l'impédance Zbat varie de quelques mOhms à quelques centaines de mOhms, en général Vz est compris entre 0 et 5% de $E_{bat}$ au maximum) ;
- la FEM à vide $E_{bat}$ varie avec l'état de charge de la batterie, ce qui rend difficile sa compensation lors de la mesure de la tension aux bornes de $Z_{bat}$ (nécessité d'une compensation adaptable) ;
- la composante fréquentielle de courant dans $Z_{bat}$ doit rester de faible amplitude par rapport au courant moyen circulant dans la batterie tandis qu'elle doit être mesurée avec une précision raisonnable (mesure autour d'un point de fonctionnement) (le courant moyen dépend du nombre d'éléments associés et varie de quelques ampères à quelques centaines d'ampères suivant l'application (par exemple de 1 A à 200 A) ; le courant alternatif doit rester faible pour que la spectroscopie soit valide et pour éviter de dégrader la source (son amplitude restera comprise par exemple entre 1% et 10% du courant nominal de la source) ;
- la valeur moyenne du courant dans la batterie peut varier suivant le niveau de charge et décharge voulu de la batterie, ce qui rend difficile sa compensation lors de la mesure du courant dans $Z_{bat}$ ;
- la commutation des transistors IGBT du convertisseur de puissance 1 produit de fortes perturbations sur le courant et la tension de batterie dans certaines gammes de fréquence, qui rendent difficiles la mesure des composantes utiles à la spectroscopie d'impédance.

L'électronique de mesure du convertisseur de puissance 1 dans un mode de mise en oeuvre de l'invention est donc réalisée pour assurer les fonctionnalités suivantes :

- mesure du courant de batterie par sonde à effet Hall (bande passante -0,5dB à 100kHz) ;
- mesure de la tension $V_1$ en prise directe sans isolation galvanique ;
- calibration du courant et de la tension par compensation de décalage (en anglais « offset ») et par gains, décalages et gains étant programmables par le microcontrôleur 10 afin de compenser les composantes continues ($E_{bat}$ et courant moyen $I_0$) et d'extraire les composantes alternatives utiles à la spectroscopie d'impédance.

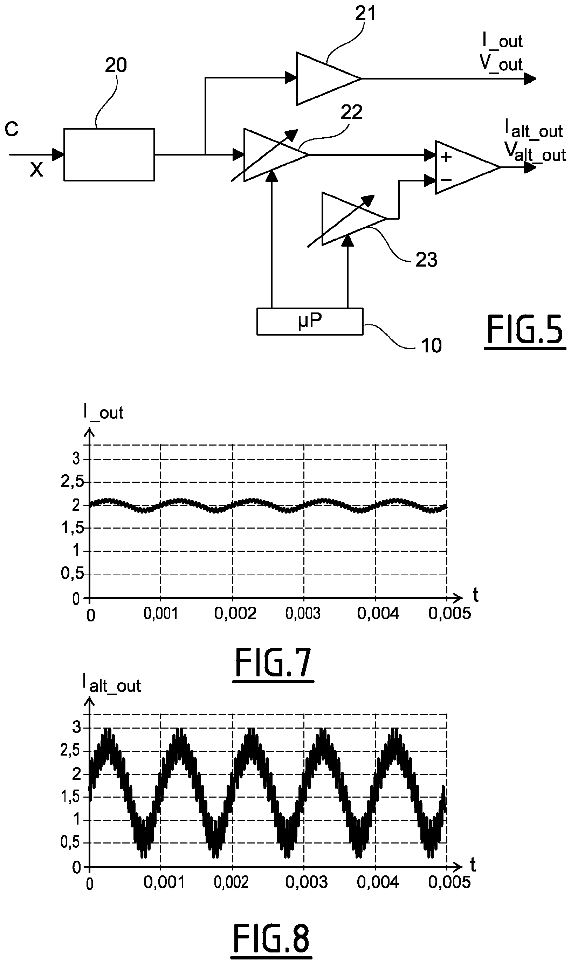

En figure 5 est représenté un schéma de principe illustrant les mesures des grandeurs électriques de tension/courant relatives à la source S par l'électronique de mesure du convertisseur de puissance 1, et le calibrage de ces mesures par le convertisseur de puissance 1.

La grandeur électrique X ($V_1$, $I_L$) est mesurée par un capteur de mesure 20 (exemple : le capteur à effet Hall LTS15NP pour le courant $I_L$), puis un calibrage fixe 21 est opéré sur la grandeur mesurée (avec une valeur de gain et une valeur de décalage fixées et fournit une image de la grandeur souhaitée (I_out pour le courant et V_out pour la tension de la batterie S). Cette image est exploitée par la fonctionnalité de transfert d'énergie. Si la fonctionnalité de spectroscopie d'impédance est mise en oeuvre à la place du transfert d'énergie par le convertisseur de puissance 1, un calibrage programmable adapté est alors opéré par une opération 22 de multiplication par une valeur de gain (pour amplifier ou diminuer la valeur mesurée) et une opération de décalage 23 de la valeur mesurée multipliée. L'image de la grandeur souhaitée Ialt_out pour le courant et Valt_out pour la tension de la batterie S) est ensuite obtenue. Les valeurs du gain et du décalage sont programmées en temps réel par le microcontrôleur 10 de la façon indiquée plus loin, via le contrôleur SPI.

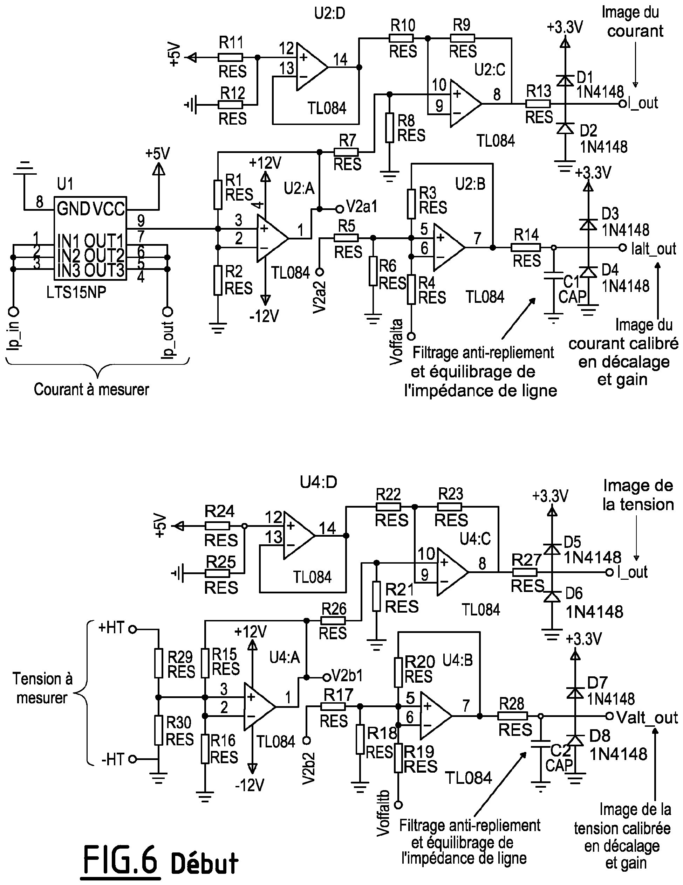

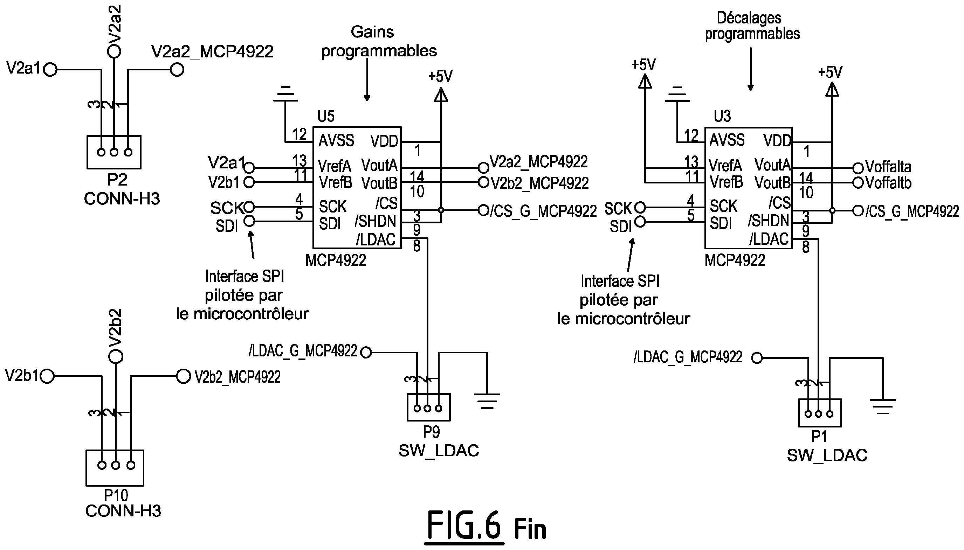

En figure 6 est représenté le schéma de la carte électronique 12 du convertisseur de puissance 1 permettant ces mesures et calibrages.

Les valeurs des composants électroniques sont définies pour :

- ajuster les gains initiaux en fonction de l'application (tension et courant nominaux de la source S, ordre de grandeur de l'impédance à mesurer)
- ajuster les fréquences de coupures des filtres antirepliement
- équilibrer les impédances de lignes des mesures des composantes alternatives de tension et de courant pour ne pas introduire de déphasage parasite entre ces lignes (calibrage des phases, l'impédance étant caractérisée par les amplitudes et les phases des composantes alternatives de tension et de courant).

Cette électronique de mesure 12 permet ainsi de récupérer pour le courant et la tension de la source S, deux « images » (ou valeurs représentatives) analogiques avant numérisation par le CA/N, comme indiqué précédemment :

- une image issue d'un calibrage fixe permettant d'évaluer la grandeur absolue du courant et/ou de la tension au niveau de la source S (sorties I_out et V_out) dans le cadre de la fonctionnalité de transfert d'énergie et utilisée pour le transfert d'énergie ;
- une image issue d'un calibrage variable programmable, permettant de mesurer uniquement la composante alternative de la grandeur et utilisée pour la spectroscopie d'impédance (sorties Ialt_out et Valt_out).

Le calibrage est réalisé pour adapter les tensions analogiques dans la plage de mesure du microcontrôleur 10. Cette plage dans le cas considéré est [0 ; 3.3V]. La valeur intermédiaire de 1,65V est prise comme référence et doit correspondre à une tension mesurée aux bornes de la source égale à 0V ou un courant circulant dans la source égal à 0A.

Les gains et décalages sont réglés numériquement par utilisation des convertisseurs numériques analogiques (par exemple de type MCP4922 à interface SPI). Ils sont définis de la manière suivante :

$$\text{Gain}: G = \frac{D_a}{4096}$$

Décalage : $V_O = 5V \cdot \dfrac{D_b}{4096}$ où $D_a$ et $D_b$ sont compris entre 0 et 4095 (précision de 12 bits).

Soit une valeur mesurée X, la valeur calibrée correspondante sera égale à :

$$G.X\text{-}V_0$$

Les figures 7, respectivement 8, illustrent le résultat attendu sur les deux sorties I_out, respectivement Ialt_out, en fonction du temps (en s) lors d'une spectroscopie, faisant apparaître la composante continue du courant (I_out), l'excitation alternative (Ialt_out) et les perturbations dues au découpage opéré par les commutateurs $T_1$, $T_2$ du convertisseur.

Comme souhaité, la composante alternative Ialt_out est bien centrée dans la plage [0-3.3] et occupe bien la plage disponible grâce au calibrage réalisé.

Le processus de spectroscopie d'impédance intégré dans le convertisseur de puissance 1 tel que mis en oeuvre à l'aide du microcontrôleur 10, est décrit plus précisément ci-dessous.

Phase A : transfert d'énergie, ie hors spectroscopie :

∘ les algorithmes de contrôle normal du transfert d'énergie mis en oeuvre notamment par le contrôleur 10 dans le convertisseur de puissance 1 sont actifs (charge/décharge de la batterie en fonctionnement et éventuellement entretien de la charge au repos).

Phase B : lorsqu'une spectroscopie d'impédance est à mettre en oeuvre par le convertisseur 1, avant la spectroscopie :

◦ Avant de mettre en oeuvre les mesures d'impédance, le contrôle du transfert d'énergie est arrêté.
◦ Le point de fonctionnement désiré de la batterie S est réglé par réglage du courant continu circulant dans la batterie S. Le rapport cyclique $\alpha_0$ du commutateur $T_1$ est défini pour obtenir un courant de valeur souhaitée $I_0$. (exemple : $I_0$ = 1A). Le spectre d'impédance sera défini pour ce point de fonctionnement particulier.
◦ Les compensations de décalage sur les mesures Ialt_out et Valt_out sont réalisées en continu pendant cette phase B pour permettre leur calibrage. Les décalages sont calculés pour maintenir la valeur Ialt_out et Valt_out à 1,65V c'est à dire sur les axes intermédiaires correspondant à 0A et 0V respectivement, et donc centrés par rapport à leur intervalle de variation.

Phase C : pendant la spectroscopie d'impédance

◦ Les compensations de décalage en temps réel sont désactivées ; les décalages mis en oeuvre sont ceux déterminés à l'issue de la phase B.
◦ La source S est excitée par injection d'un courant alternatif de fréquence d'excitation $f_i$ superposé au courant $I_0$ caractérisant le point de fonctionnement. Les fréquences d'excitation $f_i$ permettant de balayer le spectre d'impédance sont appliquées successivement. La durée d'excitation de chaque fréquence est définie en nombre de périodes du signal. Cette valeur est configurable.
◦ Pendant l'injection, les signaux alternatifs Ialt_out et Valt_out sont échantillonnés et numérisés après une attente de stabilisation de durée configurable également. Les instants d'échantillonnage sont synchronisés de manière identique pour chaque acquisition, puis sous-échantillonnés en fonction de la fréquence d'excitation.
◦ Pendant la mesure des signaux, l'impédance est calculée selon le principe suivant :

▪ Calcul des expressions complexes des raies de tension et de courant à la fréquence fi considérée par Transformée de Fourier Discrète (TFD) afin de filtrer les éventuelles perturbations sur les mesures et les composantes continues résiduelles.
▪ Calcul de l'expression complexe de l'impédance à la fréquence fi considérée.

◦ Transfert des valeurs du spectre d'impédance vers l'interface RS232 du microcontrôleur 10.

Le contrôle du transfert d'énergie doit être désactivé pendant toute la durée de la mesure du spectre d'impédance et le régime permanent de la batterie S doit être maintenu à une valeur déterminée ($I_0$) caractérisant les conditions de spectroscopie.

Le spectre d'impédance varie en effet avec le niveau de courant circulant dans la source. Pour permettre une caractérisation sans erreur de la source, il est donc nécessaire de maintenir le courant continu à une valeur connue $I_0$. Chaque spectre d'impédance sera donc défini pour un courant $I_0$ connu.

De surcroît, pour permettre la mesure sans erreur de l'impédance de la source S, il est nécessaire d'éviter toute perturbation parasite de fréquence proche ou inférieure à la composante fréquentielle considérée. Ainsi, l'algorithme de contrôle du transfert d'énergie doit être désactivé pour garder le système en régime permanent (asservissement de courant ou de la tension du réseau continu désactivé). Lorsque le point de fonctionnement désiré et donc le courant $I_0$ est atteint, le rapport cyclique $\alpha_0$ de la commande du convertisseur est figé pour que la spectroscopie d'impédance s'effectue autour de ce point de fonctionnement.

En cas de régime transitoire sur la charge, la tension de la charge (ie du réseau continu) peut s'écarter de sa valeur de référence. Si la priorité est donnée à la stabilité de la tension du réseau continu, il conviendra, dans le cas ou un transitoire de forte amplitude apparaîtrait, de mettre fin à la spectroscopie d'impédance pour reprendre le contrôle du transfert d'énergie en réactivant les asservissements qui y sont liés.

Le respect de cette condition est facilement réalisable par mesure de la tension du réseau continu.

Dans le cadre de la mesure d'impédance, un échantillonnage des signaux analogiques obtenus Ialt_out, Valt_out, réalisé par la fonction CA/N du microcontrôleur 10, doit permettre d'obtenir un signal numérique suffisamment fidèle, en évitant le phénomène de repliement et sans surcharger le microcontrôleur.

La fréquence de découpage du convertisseur 1, qui est la fréquence de commutation des commutateurs, nommée $F_{PWM} = 1/T_{PWM}$, définit la limite maximale de la fréquence de réglage du rapport cyclique et donc la limite de réglage du signal d'excitation utilisé pour la spectroscopie.

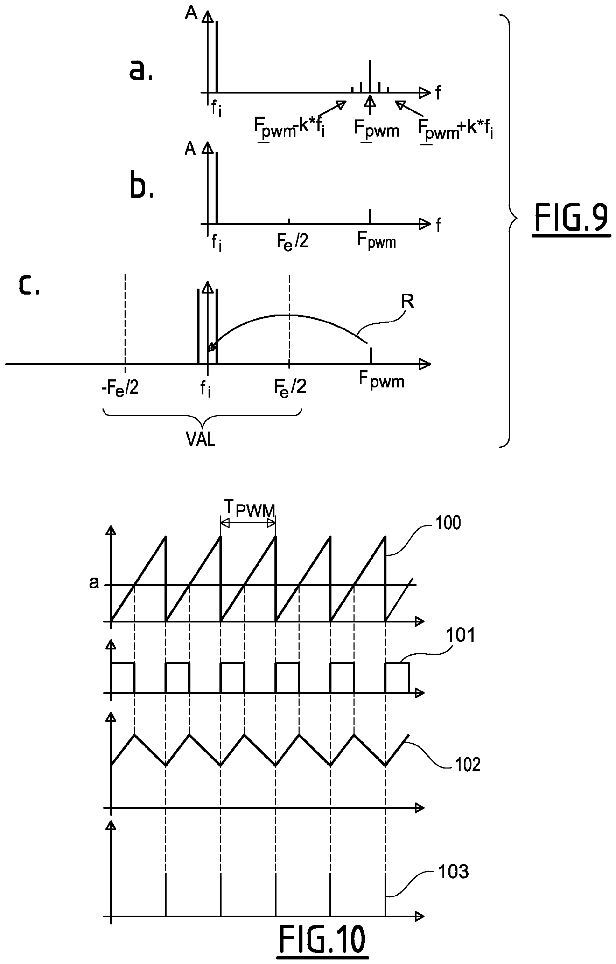

Ainsi, la fréquence d'échantillonnage n'a pas lieu d'être supérieure à $F_{PWM}$. Cependant, les signaux à mesurer étant issus d'une modulation de largeur d'impulsion, leur spectre est essentiellement constitué, comme représenté sur le graphe de la figure 9a, comportant en abscisse les fréquences et en ordonné l'amplitude :

- d'une raie principale à la fréquence de la modulante $f_i$ (fréquence d'excitation)
- d'une raie d'amplitude significative à la fréquence $F_{PWM}$ qu'il est difficile d'éliminer par filtrage anti-repliement
- de plusieurs raies de faible amplitude aux fréquences $F_{PWM} \pm n*f_i$.

Le problème peut être résolu en repoussant la fréquence d'échantillonnage au-delà de $2*F_{PWM}$ et en décimant (ou sous-échantillonnant) éventuellement dans un deuxième temps le signal échantillonné après filtrage numérique. Cette stratégie à pour inconvénient d'augmenter considérablement la charge de calcul et de requérir un microcontrôleur de puissance plus importante et donc plus coûteux.

Le principe d'échantillonnage retenu dans le mode de réalisation considéré permet de rejeter les harmoniques tout en conservant une fréquence d'échantillonnage basse $F_e = F_{PWM}$.

Il consiste à effectuer dans un premier temps un filtrage analogique anti-repliement partiel éliminant les harmoniques de faible amplitude peu gênants de fréquence supérieure à $F_e/2$. Le spectre du signal à mesurer (Ialt_out ou Valt_out) après filtrage anti-repliement partiel est représenté en figure 9b. Cette fonctionnalité de filtrage est réalisée par l'électronique de mesure analogique décrite en référence à la figure 6.

L'échantillonnage est ensuite réalisé de manière synchrone à la commutation des commutateurs $T_1$, $T_2$, ce qui permet de caler sur la fréquence égale à 0 Hz le repliement de la raie située à $F_{PWM}$ de sorte à ce qu'elle ne perturbe pas la mesure des raies d'excitation utiles à la spectroscopie d'impédance ($f_i$). Le spectre du signal échantillonné à la fréquence $F_e = F_{PWM}$ est représenté en figure 9c. La flèche R indique le repliement vers 0 Hz de la raie située à $F_{PWM}$.

Ainsi, la zone de validité VAL de la transformé de Fourier discrète (TFD) limitée par la fréquence critique de Nyquist $F_e/2$ contient uniquement la raie à la fréquence d'excitation $f_i$ et une composante continue qui dépend de l'instant d'échantillonnage dans l'intervalle $T_e = T_{PWM}$. Les raies à la fréquence $f_i$ de tension et de courant peuvent donc être mesurées sans erreur par TFD.

La figure 10 représente pour une même abscisse représentant le temps t temps, l'évolution de signaux de réglage (courbe 100), du signal de commande du commutateur $T_1$ (courbe 101), du courant dans la source S (courbe 102) et le signal échantillonné à $F_e = F_{PWM}$.

En référence à la courbe 100, il est utilisé un compteur et un comparateur pour régler $F_{PWM}$ et le rapport cyclique $\alpha$, permettant de limiter les variations du courant telles que représentées en figure 102.

La courbe 101 représente le signal de commande du commutateur T1 obtenu pour les valeurs de la fréquence $F_{PWM}$ et du rapport cyclique $\alpha$ de la courbe 100.

La courbe 102 représente le courant dans la source résultant de l'application d'un tel signal de commande.

La courbe 103 illustre le signal échantillonné à $F_e = F_{PWM}$ dans le cas d'un échantillonnage synchrone au découpage effectué par les commutateurs.

Le signal obtenu peut être sous-échantillonné sans risque de repliement, dans le cas de signaux d'excitation basse fréquence qui requièrent une faible fréquence d'échantillonnage.

Dans le mode de réalisation considéré, un unique processeur est utilisé pour le contrôle du convertisseur de puissance et pour la spectroscopie d'impédance, ce qui permet de minimiser les opérations matérielles et logicielles.

Comme indiqué ci-dessus, l'algorithme de spectroscopie intégrée est cadencé par une fréquence d'échantillonnage $F_e$ égale à la fréquence de commutation des commutateurs du convertisseur ($F_{PWM}$). Toutes les acquisitions sont réalisées à cette fréquence $F_e = F_{PWM}$, puis éventuellement sous-échantillonnées.

Afin de permettre un respect rigoureux des fréquences d'excitation $f_i$, celles-ci sont définies par la relation suivante :

$$f_i = \frac{F_e}{k \cdot N_{pts\_spect}}$$

Avec : $N_{pts\_spect}$ : nombre de points par période du signal à mesurer et k : entier permettant de définir la fréquence de la raie (avec $k \geq 1$).

Le produit $k.N_{pts\_spect}$ est limité à $2^{16}$ pour garder un codage sur 16 bits de l'algorithme (et éviter l'augmentation de la charge CPU qu'occasionnerait un codage sur 32 bits). La zone fréquentielle observable est donc dans ce cas donnée par :

$$\frac{F_e}{2^{16}-1} \leq f_i \leq \frac{F_e}{N_{pts\_spect}}$$

Par exemple, avec $F_e$ = 20480 Hz, $N_{Pts\_spect}$ = 20, on a $0{,}312 Hz \leq f_i \leq 1024 Hz$.

Les algorithmes de contrôle du transfert d'énergie étant désactivés, l'excitation de la source S se fait par injection d'un courant d'amplitude constante de fréquences successives choisies dans la bande de fréquence considérée, superposé au courant continu $I_0$ définissant le point de fonctionnement, comme décrit ci-dessus.

Le courant d'excitation est contrôlé par un correcteur proportionnel (P) assurant le respect de son amplitude et de sa fréquence. La commande du rapport cyclique d$\alpha$ assurant le contrôle du courant d'excitation est superposée à la valeur $\alpha_0$ maintenue constante à la suite du réglage du point de fonctionnement à $I = I_0$.

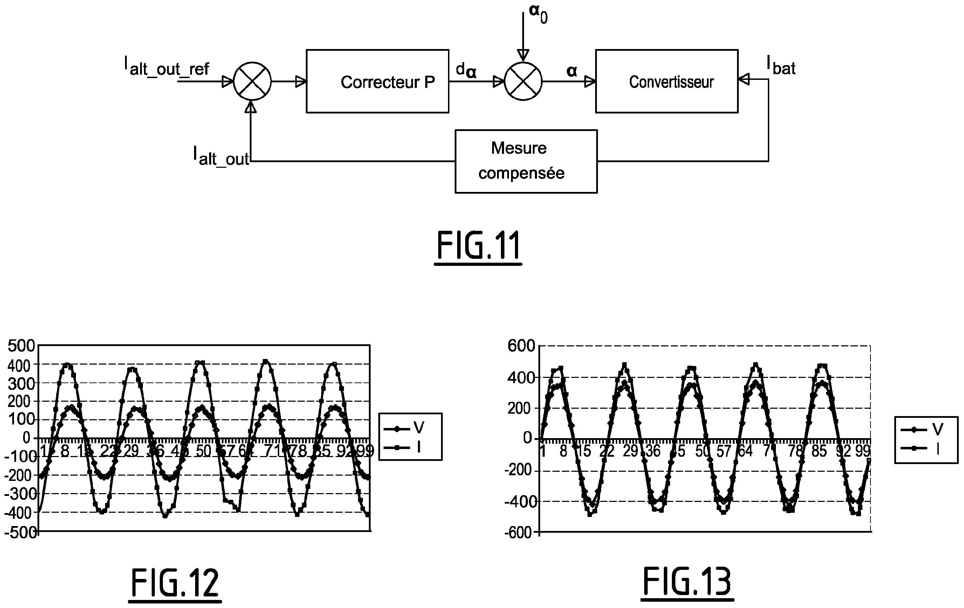

Le principe d'asservissement correspondant est représenté en figure 11.

La fréquence du courant alternatif superposé $I_{alt\_out\_ref}$ est définie par la fréquence $f_i$ de la raie fréquentielle considérée. Son amplitude $I_{max}$ est définie assez faible devant le courant nominal $I_0$ de la source (exemple : $I_{max}$ compris entre 1% et 10% du courant nominal de la source) et reste inchangée quelle que soit la raie. $I_{alt\_out\_ref}$ est construit à partir d'une table précalculée d'un signal sinusoïdal de précision angulaire $2_{\pi}/1000$ et de précision d'amplitude 1/500ème.

$$I_{alt\_out\_ref} = I_{max} \cdot \sin(2\pi f_i t)$$

On mesure des valeurs de tension $V_{alt\_out}$ et courant $I_{alt\_out}$, pour chaque fréquence d'excitation en définissant les paramètres suivants, par fréquence d'excitation :

- le nombre de périodes de mesure
- le nombre de points par période ($N_{pts\_spect}$).

A nombre de points de mesure par période constant, la fréquence d'échantillonnage des signaux utilisés pour la spectroscopie varie en fonction de la fréquence de la raie et donc de k : $F_{ech\_spect} = \dfrac{F_e}{k}$.

Ainsi les signaux sont échantillonnés à $F_e$ puis sous-échantillonnés, pour la spectroscopie, en fonction de la fréquence $f_i$ de la raie considérée.

Le nombre k permet de régler le sous-échantillonnage en fonction de la fréquence de la raie (pour avoir toujours Npts_spect points par période même quand la fréquence de la raie change).

L'excitation de la batterie avant l'acquisition pendant un nombre entier de période(s) permet d'éliminer tout risque éventuel de mesure de phénomènes transitoires dus au démarrage de l'injection ou au changement de sa fréquence.

La figure 12, respectivement la figure 13, avec en abscisse le numéro d'échantillon et en ordonné le résultat numérique de conversion analogique/numérique, illustre les résultats de mesures des composantes alternatives de la tension (V) et du courant (I) obtenus à une fréquence d'excitation de 1024 Hz, respectivement 0,32 Hz, pour 5 périodes et 20 points par période.

On peut noter en particulier l'efficacité de la rejection des harmoniques à la fréquence $F_{PWM}$ (Les perturbations visibles sur la courbe de la figure 8 ont été supprimées sur les courbes des figures 12 et 13 qui sont alors quasi-sinusoïdales).

Comme indiqué plus haut, chaque raie de courant et de tension est extraite par TFD du signal mesuré. Les N échantillons d'un signal obtenus suite à excitation à la fréquence $f_i$ permettent d'obtenir les parties réelles et imaginaires de l'harmonique de rang $k_h$ et de fréquence $f_i$. Le rang $k_h$ de la raie ayant la fréquence d'excitation représente également le nombre de périodes de mesure (c'est-à-dire que $N = k_h \cdot N_{pts\_spect}$ : le nombre d'échantillons total est égal au nombre d'échantillons par période que multiplie le nombre de périodes) :

$$\begin{cases} \mathrm{Re}(V_{alt\_out}) = \dfrac{2}{N}\sum_{n=0}^{N-1} V_{alt\_out}(n).\cos(2\pi k_h n/N) = \dfrac{2}{N}\sum_{n=0}^{N-1} V_{alt\_out}(n).\cos(2\pi n/N_{pts\_spect}) \\[4mm] \mathrm{Im}(V_{alt\_out}) = -\dfrac{2}{N}\sum_{n=0}^{N-1} V_{alt\_out}(n).\sin(2\pi k_h n/N) = -\dfrac{2}{N}\sum_{n=0}^{N-1} V_{alt\_out}(n).\sin(2\pi n/N_{pts\_spect}) \end{cases}$$

$$\begin{cases} \mathrm{Re}(I_{alt\_out}) = \dfrac{2}{N}\sum_{n=0}^{N-1} I_{alt\_out}(n).\cos(2\pi k_h n/N) = \dfrac{2}{N}\sum_{n=0}^{N-1} I_{alt\_out}(n).\cos(2\pi n/N_{pts\_spect}) \\[2em] \mathrm{Im}(I_{alt\_out}) = -\dfrac{2}{N}\sum_{n=0}^{N-1} I_{alt\_out}(n).\sin(2\pi k_h n/N) = -\dfrac{2}{N}\sum_{n=0}^{N-1} I_{alt\_out}(n).\sin(2\pi n/N_{pts\_spect}) \end{cases}$$

L'impédance est alors déduite des expressions complexes du courant et de la tension :

$$\begin{cases} \mathrm{Re}(Z) = \dfrac{\mathrm{Re}(V_{alt\_out}) \cdot \mathrm{Re}(I_{alt\_out}) + \mathrm{Im}(V_{alt\_out}) \cdot \mathrm{Im}(I_{alt\_out})}{\mathrm{Re}^2(I_{alt\_out}) + \mathrm{Im}^2(I_{alt\_out})} \\[2em] \mathrm{Im}(Z) = \dfrac{\mathrm{Re}(I_{alt\_out}) \cdot \mathrm{Im}(V_{alt\_out}) - \mathrm{Re}(V_{alt\_out}) \cdot \mathrm{Im}(I_{alt\_out})}{\mathrm{Re}^2(I_{alt\_out}) + \mathrm{Im}^2(I_{alt\_out})} \end{cases}$$

Le calcul est réalisé pour chaque raie du spectre. Ainsi l'excitation de la source successivement à différentes fréquences $f_i$ choisies pour balayer la largeur de spectre désirée, la mesure de $I_{alt\_out}$ et $V_{alt\_out}$ puis le calcul de l'impédance à chacune de ces fréquences, permet alors de constituer le spectre d'impédance pour la largeur de spectre considérée.

L'invention peut être mise en oeuvre avec des microcontrôleurs comportant des processeurs courants et à bas coût du monde industriel.

Elle permet de mesurer avec précision les valeurs d'impédance et se révèle très intéressante notamment dans le cas de sources d'énergie embarquées, puisqu'elle permet de réaliser les mesures in situ.

## Revendications

1.  Convertisseur électronique de puissance (1), adapté pour, dans un premier mode de fonctionnement, recevoir en entrée des grandeurs électriques de tension et/ou courant depuis un premier dispositif (S), pour les traiter à l'aide de moyens de traitement (10, 12) aptes à mesurer lesdites grandeurs électriques et à asservir lesdites grandeurs électriques en fonction desdites mesures et de contraintes propres à un deuxième dispositif, et pour fournir les grandeurs adaptées de tension et/ou courant audit deuxième dispositif, le convertisseur électronique de puissance comprenant en outre des moyens pour déterminer l'impédance de la source d'énergie à une fréquence fixée, en fonction de valeurs de courant et tension mesurées aux bornes de la source d'énergie, ledit convertisseur électrique étant **caractérisé en ce que** :

    le convertisseur de puissance est adapté pour, dans un premier état d'un deuxième mode de fonctionnement du convertisseur, lorsqu'un des premier et deuxième dispositifs est une source d'énergie électrique (S), imposer la présence d'un courant continu d'une valeur déterminée ($I_0$) aux bornes de ladite source d'énergie ;
    le convertisseur de puissance est adapté en outre pour mesurer des valeurs de courant et tension aux bornes de la source d'énergie pendant ledit premier état du deuxième mode de fonctionnement, pour déterminer, en fonction desdites valeurs de courant mesurées, une valeur de décalage en courant et, en fonction desdites valeurs de tension mesurées, une valeur de décalage en tension, lesdites valeurs de décalage de courant et de tension étant en fonction en outre d'une plage de fonctionnement des moyens de traitement ;
    le convertisseur de puissance est adapté pour exciter, dans un deuxième état du deuxième mode de fonctionnement, la source d'énergie par injection d'un courant alternatif à au moins une fréquence d'excitation fixée, ledit courant alternatif étant superposé au courant continu imposé déterminé ;
    et dans lequel les moyens de traitement sont adaptés, dans le deuxième état du deuxième mode de fonctionnement, pour mesurer des valeurs successives de courant et tension (Ialt-out, Valt-out) aux bornes de la source d'énergie suite à l'excitation à ladite fréquence d'excitation, après décalage desdites valeurs de courant, respectivement desdites valeurs de tension, en fonction de ladite valeur de décalage en courant déterminée, respectivement, de ladite valeur de décalage en tension déterminée ;
    lesdits moyens pour déterminer l'impédance de la source d'énergie étant adaptés pour déterminer l'impédance de la source d'énergie à ladite fréquence d'excitation fixée, en fonction desdits valeurs de courant et de tension successivement mesurées..

**2.** Convertisseur électronique de puissance (1) selon la revendication 1, la valeur de décalage en courant, respectivement, la valeur de décalage en tension, est déterminée de manière à ce qu'une tension, respectivement un courant, mesuré(e) aux bornes de la source d'énergie pendant le premier état d'un deuxième mode de fonctionnement ajouté(e) à ladite valeur de décalage en courant, respectivement en tension, soit égal(e) au point central de la plage de fonctionnement des moyens de traitement.

**3.** Convertisseur électronique de puissance (1) selon la revendication 1 ou 2, adapté pour, dans le deuxième état du deuxième mode de fonctionnement, exciter la source d'énergie (S) par injection d'un courant alternatif superposé au courant continu de ladite valeur déterminée, à plusieurs fréquences d'excitation successives fixées ; les moyens de traitement étant aptes à mesurer des valeurs successives de courant et tension aux bornes de la source d'énergie suite à l'excitation de chaque fréquence d'excitation, après décalage desdites valeurs de courant, respectivement desdites valeurs de tension, en fonction de ladite valeur de décalage en courant déterminée, respectivement, de ladite valeur de décalage en tension déterminée ;
les moyens pour déterminer l'impédance étant adaptés pour déterminer l'impédance de la source d'énergie pour chaque fréquence d'excitation fixée, en fonction des valeurs de courant et tension successivement mesurées.

**4.** Convertisseur électronique de puissance selon l'une quelconque des revendications 1 à 3, dans lequel les moyens de traitement sont aptes, dans le deuxième état du deuxième mode de fonctionnement, à mesurer des valeurs successives de courant et tension aux bornes de la source d'énergie suite à l'excitation à ladite fréquence d'excitation, et après décalage desdites valeurs de courant, respectivement de tension, et après application d'une valeur multiplicative audites valeurs de courant, respectivement de tension, déterminée en fonction de l'excursion desdites valeurs mesurées et de la plage de fonctionnement des premiers moyens.

**5.** Convertisseur électronique de puissance selon l'une des revendications précédentes, comprenant au moins un commutateur commandé, dans le premier mode et le deuxième mode de fonctionnement par un signal en créneau correspondant à une fréquence de commande et un rapport cyclique donnés, le convertisseur de puissance étant adapté, dans le premier état du deuxième mode de fonctionnement, pour faire varier la valeur du rapport cyclique jusqu'à obtenir ladite valeur déterminée du courant continu aux bornes de ladite source d'énergie.

**6.** Convertisseur électronique de puissance selon l'une des revendications précédentes, comprenant au moins un commutateur commandé, dans le premier mode et le deuxième mode de fonctionnement, par un signal en créneau à une fréquence de commande donnée ;
et les moyens de traitement sont aptes, dans le deuxième état du deuxième mode de fonctionnement, à mesurer des valeurs successives de courant et tension aux bornes de la source d'énergie suite à l'excitation à ladite fréquence d'excitation, à une fréquence d'échantillonnage égale à la fréquence de commande ou à un sous-multiple entier de cette fréquence de commande.

**7.** Convertisseur électronique de puissance selon la revendication précédente, dans lequel une fréquence d'excitation est définie par la relation suivante :

$$F_{exc} = \frac{F_e}{k \cdot N_{pts\_spect}}$$

où $F_{exc}$ est la fréquence d'excitation, $F_e$ la fréquence d'échantillonnage, $N_{pts\_spect}$ est le nombre de points, par période, de la valeur à mesurer à cette fréquence d'excitation, $F_{exc}$ et k entier supérieur ou égal à 1.

**Patentansprüche**

**1.** Elektronischer Leistungswandler (1), welcher eingerichtet ist, um, in einem ersten Betriebsmodus, am Eingang elektrische Größen von Spannung und/oder Strom von einer ersten Vorrichtung (S) zu erhalten, diese mittels Verarbeitungsmitteln (10, 12), welche dazu eingerichtet sind, die elektrischen Größen zu messen und die elektrischen Größen in Abhängigkeit von den Messungen und von für eine zweite Vorrichtung spezifischen Beschränkungen zu regeln, zu verarbeiten und die angepassten Größen von Spannung und/oder Strom an die zweite Vorrichtung zu liefern, wobei der elektronische Leistungswandler ferner Mittel zum Bestimmen der Impedanz der Energiequelle mit einer festen Frequenz in Abhängigkeit von den an den Anschlüssen der Energiequelle gemessenen Werten von Strom und Spannung aufweist, wobei der elektronische Leistungswandler **dadurch gekennzeichnet ist, dass**:

der Leistungswandler eingerichtet ist, um, in einem ersten Zustand eines zweiten Betriebsmodus des Wandlers, wenn eine von der ersten und der zweiten Vorrichtung eine elektrische Energiequelle (S) ist, das Vorhandensein eines Gleichstroms von einem bestimmten Wert ($I_0$) an den Anschlüssen der Energiequelle aufzuerlegen, der Leistungswandler ferner eingerichtet ist, um die Werte von Strom und Spannung an den Anschlüssen der Energiequelle während des ersten Zustands des zweiten Betriebsmodus zu messen, in Abhängigkeit von den gemessenen Stromwerten einen Strom-Verschiebungswert zu bestimmen und in Abhängigkeit von den gemessenen Spannungswerten einen Spannung-Verschiebungswert zu bestimmen, wobei die Verschiebungswerte von Strom und Spannung ferner von einem Betriebsbereich der Bearbeitungsmittel abhängig sind, der Leistungswandler eingerichtet ist, um, in einem zweiten Zustand des zweiten Betriebsmodus, die Energiequelle anzuregen durch Einbringen eines Wechselstroms mit mindestens einer festen Anregungsfrequenz, wobei der Wechselstrom dem auferlegten, bestimmten Gleichstrom überlagert ist, und wobei die Verarbeitungsmittel eingerichtet sind, um, in einem zweiten Zustand des zweiten Betriebsmodus, aufeinanderfolgende Werte von Strom und Spannung (Ialt-out, Valt-out) an den Anschlüssen der Energiequelle im Anschluss an die Anregung mit der Anregungsfrequenz zu messen, nach Verschieben der Stromwerte bzw. Spannungswerte in Abhängigkeit von dem bestimmten Strom-Verschiebungswert bzw. bestimmten Spannung-Verschiebungswert, wobei die Mittel zum Bestimmen der Impedanz der Energiequelle eingerichtet sind, um die Impedanz der Energiequelle bei der festen Anregungsfrequenz in Abhängigkeit von den aufeinanderfolgend gemessenen Werten von Strom und Spannung zu bestimmen.

2. Elektronischer Leistungswandler (1) gemäß dem Anspruch 1, wobei der Strom-Verschiebungswert bzw. der Spannung-Verschiebungswert so bestimmt wird, dass eine/ein an den Anschlüssen der Energiequelle während dem ersten Zustand eines zweiten Betriebsmodus gemessene(r), mit dem Strom-Verschiebungswert bzw. Spannung-Verschiebungswert addierte(r) Spannung bzw. Strom gleich einem Mittelpunkt des Betriebsbereichs der Verarbeitungsmittel wird.

3. Elektronischer Leistungswandler (1) gemäß dem Anspruch 1 oder 2, welcher eingerichtet ist, um, in dem zweiten Zustand des zweiten Betriebsmodus, die Energiequelle (S) anzuregen mittels Einbringens eines dem Gleichstrom des bestimmten Werts überlagerten Wechselstroms mit mehreren aufeinanderfolgenden, festen Anregungsfrequenzen, wobei die Verarbeitungsmittel eingerichtet sind, um aufeinanderfolgende Werte von Strom und Spannung an den Anschlüssen der Energiequelle im Anschluss an die Anregung von jeder Anregungsfrequenz zu messen, nach Verschieben besagter Stromwerte bzw. besagter Spannungswerte in Abhängigkeit von dem bestimmten Strom-Verschiebungswert bzw. dem bestimmten Spannung-Verschiebungswert, wobei die Mittel zum Bestimmen der Impedanz dazu eingerichtet sind, die Impedanz der Energiequelle für jede feste Anregungsfrequenz in Abhängigkeit von den aufeinanderfolgend gemessenen Werten von Strom und Spannung zu bestimmen.

4. Elektronischer Leistungswandler gemäß irgendeinem der Ansprüche 1 bis 3, wobei die Verarbeitungsmittel eingerichtet sind, um, in dem zweiten Zustand des zweiten Betriebsmodus, aufeinanderfolgende Werte von Strom und Spannung an den Anschlüssen der Energiequelle zu messen im Anschluss an die Anregung mit der Anregungsfrequenz, und nach Verschieben besagter Werte von Strom bzw. Spannung und nach Anwenden eines Multiplikationswerts auf besagte Werte von Strom bzw. Spannung, welcher in Abhängigkeit von der Abweichung der besagten gemessenen Werten und dem Betriebsbereich des ersten Mittels bestimmt ist.

5. Elektronischer Leistungswandler gemäß irgendeinem der vorangehenden Ansprüche, aufweisend mindestens einen Schalter, welcher in dem ersten Betriebsmodus und dem zweiten Betriebsmodus mittels eines gegebenen Rechteck-Signals, welches mit einer Steuerfrequenz korrespondiert, und eines gegebenen Tastverhältnisses gesteuert wird, wobei, in dem ersten Zustand des zweiten Betriebsmodus, der Leistungswandler eingerichtet ist, um den Wert des Tastverhältnisses zu verändern, bis der bestimmte Wert des Gleichstroms an den Anschlüssen der Energiequelle erhalten wird.

6. Elektronischer Leistungswandler gemäß irgendeinem der vorangehenden Ansprüche, aufweisend mindestens einen Schalter, welcher in dem ersten Betriebsmodus und dem zweiten Betriebsmodus mittels eines Rechteck-Signals mit einer gegebenen Steuerfrequenz gesteuert wird, und die Verarbeitungsmittel eingerichtet sind, um, in dem zweiten Zustand des zweiten Betriebsmodus, aufeinanderfolgende Werte von Strom und Spannung an den Anschlüssen der Energiequelle im Anschluss an die Anregung mit der Anregungsfrequenz, mit einer Abtastfrequenz, welche gleich der Steuerfrequenz ist, oder mit einem ganzzahligen Bruchteil dieser Steuerfrequenz zu messen.

7. Elektronischer Leistungswandler gemäß dem vorangehenden Anspruch, wobei eine Anregungsfrequenz definiert ist durch die folgende Gleichung:

$$F_{exc} = \frac{F_e}{k \cdot N_{pts\_spect}}$$

wobei $F_{exc}$ die Anregungsfrequenz ist, $F_e$ die Abtastfrequenz ist, $N_{pts\_spect}$ die Zahl von Punkten pro Periode des bei der Anregungsfrequenz zu messenden Werts, wobei $F_{exc}$ und k ganze Zahlen größer oder gleich 1 sind.

**Claims**

1. An electronic power converter (1), suitable, in a first mode, for receiving electrical voltage and/or current quantities from a first device (S) as input, for processing them using processing means (10, 12) capable of measuring said electrical quantities and servocontrolling said electrical quantities based on said measurements and constraints specific to a second device, and for providing the adapted voltage and/or current quantities to said second device, the electronic power converter further comprising means for determining the impedance of the energy source at a given frequency, based on intensity and voltage values measured across the terminals of the energy source, said electric converter being **characterized in that**:

   the power converter is suitable for, in a first state of a second mode of the converter, when one of the first and second devices is an electricity source (S), imposing a direct current having a predetermined value ($I_0$) across the terminals of said energy source;
   the power converter is further suitable for measuring current and voltage values across the terminals of the energy source during said first state of the second mode, for determining, as a function of said measured current values, a current offset value and, as a function of said measured voltage values, a voltage offset value, said current and voltage offset values being further function of an operating range of the processing means;
   the power converter is suitable for exciting, in a second state of the second mode, the energy source by injecting alternating current at least at one fixed excitation frequency, said alternating current being superimposed on the determined imposed direct current;
   and wherein the processing means are suitable, in the second state of the second mode, for measuring successive current and voltage values (Ialt-out, Valt-out) across the terminals of the energy source following the excitation at said excitation frequency, after offsetting said current values, voltage values, respectively, as a function of said determined current offset value, said determined voltage offset value, respectively;
   said means for determining the impedance of the energy source being suitable for determining the impedance of the energy source at the fixed excitation frequency, based on said intensity and voltage values measured successively.

2. The electronic power converter (1) according to claim 1, the current offset value, voltage offset value, respectively, is determined such that a voltage, a current, respectively, measured across the terminals of the energy source during the first state of a second mode added to said current offset value, voltage offset value, respectively, is equal to the central point of the operating range of the processing means.

3. The electronic power converter (1) according to claim 1 or 2, suitable, in the second state of the second mode, for exciting the energy source (S) by injecting an alternating current superimposed on the direct current of said predetermined value, at several successive fixed excitation frequencies;
   the processing means being able to measure successive current and voltage values across the terminals of the energy source following the excitation of each excitation frequency, after offsetting said current values, voltage values, respectively, as a function of said determined current offset value, said determined voltage offset value, respectively;
   the means for determining the impedance being suitable for determining the impedance of the energy source for each fixed excitation frequency, as a function of the successively measured current and voltage values.

4. The electronic power converter according to any one of claims 1 to 3, wherein the processing means are able, in the second state of the second mode, to measure successive current and voltage values across the terminals of the energy source following the excitation at said excitation frequency, and after offsetting said current values, voltage values, respectively, and after applying a multiplicative value to said current values, voltage values, respectively, determined as a function of the deviation of said measured values and the operating range of the first means.

5. The electronic power converter according to one of the preceding claims, including at least one switch commanded, in the first mode and the second mode, by a square wave corresponding to a given command frequency cyclic ratio, the power converter being suitable, in the first state of the second mode, for varying the value of the cyclic ratio until said determined value of the direct current is obtained across the terminals of said energy source.

6. The electronic power converter according to one of the preceding claims, including at least one switch commanded, in the first mode and the second mode, by a square wave at a given command frequency,
and the processing means are able, in the second state of the second mode, to measure successive current and voltage values across the terminals of the energy source following the excitation at said excitation frequency, at a sampling frequency equal to the command frequency or a whole sub-multiple of that command frequency.

7. The electronic power converter according to the preceding claim, wherein an excitation frequency is defined by the following relationship:

$$F_{exc} = \frac{F_e}{k \cdot N_{pts\_spect}}$$

where $F_{exc}$ is the excitation frequency, $F_e$ is the sampling frequency, $N_{pts\_spect}$ is the number of points, per period, of the value to be measured at that excitation frequency, $F_{exc}$ and k is integer greater than or equal to 1.

FIG.1

FIG.2

FIG.3

FIG.4

**FIG.5**

**FIG.7**

**FIG.8**

**FIG.6** Début

EP 2 710 390 B1

FIG.6 Fin

FIG.9

FIG.10

EP 2 710 390 B1

$\alpha_0$

$I_{alt\_out\_ref}$ → Correcteur P → $d_\alpha$ → $\alpha$ → Convertisseur ← $I_{bat}$

$I_{alt\_out}$ ← Mesure compensée

## FIG.11

### FIG.12

V
I

### FIG.13

V
I

**EP 2 710 390 B1**

## RÉFÉRENCES CITÉES DANS LA DESCRIPTION

### Documents brevets cités dans la description

- WO 2011004249 A2